# EUROPEAN PATENT APPLICATION

(11) **EP 4 823 288 A1**
(43) Date of publication of application: **14.10.2026**
(21) Application number: 24915666.2
(22) Date of filing: 29.10.2024
(51) Int. Cl.: H10H 20/853, H10H 20/857

(54) **LIGHT SOURCE DEVICE**

(30) Priority: 04.01.2024 JP 2024000050
(71) Applicant: USHIO DENKI KABUSHIKI KAISHA, Tokyo 100-8150 (JP)
(72) Inventor: OUCHI, Yasuhiro, Tokyo 100-8150 (JP)
(74) Representative: Maiwald GmbH
(86) International application number: PCT/JP2024/038518
(87) International publication number: WO 2025/146743

(57) **Abstract**

A light source device comprising: an **LED** substrate including, on a main surface, a first conductive layer and a second conductive layer that are each formed of a metal material and provided adjacent to each other; an **LED** element placed on the second conductive layer and including a first electrode provided on a light-emitting surface and a second electrode provided on a surface opposite to the light-emitting surface; a wire connecting the first electrode of the **LED** element and the first conductive layer; a metal bonding layer formed on the second conductive layer between the **LED** element and the second conductive layer and containing at least silver; and a resin layer formed along a periphery of the **LED** element and covering a surface of the metal bonding layer, wherein, in a direction in which the wire extends, the resin layer is formed in a narrow path along a side surface of the **LED** element between the **LED** element and an end portion of the second conductive layer, or between the **LED** element and a partition portion provided on the second conductive layer.

## Description

### TECHNICAL FIELD

The present invention relates to a light source device, and particularly relates to a light source device including a light-emitting diode (LED) element.

### BACKGROUND ART

A light source device equipped with an LED element is generally realized by mounting the LED element on a mounting substrate according to the application. As a material used when the LED element is mounted on the substrate, a silver (Ag) paste is often employed in consideration of heat dissipation performance, cost, and the like.

In a light source device in which an LED element is mounted using silver paste, when a voltage is applied to the LED element in a high-humidity environment, a phenomenon referred to as migration occurs in the vicinity of an electrode (anode) of the LED element (the phenomenon may also be referred to as "ion migration"). The migration here is specifically a phenomenon in which silver contained in the silver paste and moisture present around the LED element come into contact in the vicinity of the electrode, and a voltage is applied thereto, whereby silver or silver oxide is deposited.

While a voltage is applied to the LED element, as long as silver and moisture are present, silver and silver oxide are continuously deposited due to this migration. A substance deposited in the vicinity of one electrode of the LED element gradually spreads in a stain shape toward the other electrode side, and eventually, the substance deposited due to the migration may short-circuit the electrodes. A short circuit between the electrodes leads to non-lighting or destruction of the LED element, and thus greatly affects reliability. For this reason, a method of suppressing the occurrence of the migration as described above has been studied.

### PRIOR ART DOCUMENT

### PATENT DOCUMENT

Patent Document 1: JP-B2-6139427

### SUMMARY OF THE INVENTION

### PROBLEMS TO BE SOLVED BY THE INVENTION

For example, Patent Document 1 describes a method of suppressing the occurrence of migration by suppressing irradiation of silver paste with light returned toward the LED element side (also referred to as "return light") among light emitted from the LED element. The method described in Patent Document 1 is intended to suppress the occurrence of migration by suppressing ionization of silver caused by irradiation of silver paste with light emitted from the LED element.

However, in the structure described in Patent Document 1, a recess formed in a substrate on which the LED element is mounted accommodates the LED element and is filled with a light-shielding material for shielding a portion of light traveling toward the silver paste. The recess described in Patent Document 1 has an opening slightly larger than the light-emitting surface of the LED element.

Forming a recess in the substrate on which the LED element is mounted and filling the recess with an appropriate amount of light-shielding material may complicate the structure of the light source device, increase the number of manufacturing steps and manufacturing cost, and further require more precise control in a mounting process for the LED element. Therefore, the structure described in Patent Document 1 has a problem in that the structure is difficult to employ in practice due to the reasons described above.

In view of the above problem, an object of the present invention is to provide a light source device in which occurrence of migration is suppressed.

### MEANS FOR SOLVING THE PROBLEMS

A light source device of the present invention includes:
a light-emitting diode (LED) substrate including, on a main surface, a first conductive layer and a second conductive layer that are each formed of a metal material and provided adjacent to each other;
an LED element placed on the second conductive layer and including a first electrode provided on a light-emitting surface and a second electrode provided on a surface opposite to the light-emitting surface;
a wire connecting the first electrode of the LED element and the first conductive layer;
a metal bonding layer formed on the second conductive layer between the LED element and the second conductive layer and containing at least silver; and
a resin layer formed along a periphery of the LED element and covering a surface of the metal bonding layer.

In a direction in which the wire extends, the resin layer is formed in a narrow path along a side surface of the LED element between the LED element and an end portion of the second conductive layer, or between the LED element and a partition portion provided on the second conductive layer.

In the present specification, the "direction in which the wire extends" is used to mean a direction along a line connecting connection points to which respective end portions of the wire are connected. That is, in an actual device, even when the wire extends straight or when the wire is bent or meanders, the "direction in which the wire extends" is specified based on the positions of the respective connection points to which the wire is connected.

Further, in the present specification, the "narrow path" refers to a gap portion formed on a region of the second conductive layer and remaining between the LED element and the end portion of the second conductive layer or between the LED element and a partition portion provided on the second conductive layer, and is a region in which a separation distance between the LED element and the end portion of the second conductive layer or between the LED element and the partition portion provided on the second conductive layer is 3 mm or less in width. Since a resin material is more likely to spread by wetting along the narrow path as the width of the narrow path decreases, the width of the narrow path is preferably 2 mm or less, and more preferably 1 mm or less. By forming such a narrow path, a resin layer is easily formed in a desired region even when the amount of the resin material is small, and the surface of the metal bonding layer is easily covered with the resin layer. Note that the narrow path is not limited to a path having a predetermined width, and is also assumed to be a portion of the mounting portion that appears around the LED element as viewed from a direction orthogonal to a light-emitting surface of the LED element as a result of the LED element being disposed on the mounting portion on the second conductive layer.

Further, although described in detail in the section "DETAILED DESCRIPTION FOR CARRYING OUT THE INVENTION", the partition portion here may be any portion having a structure that exhibits a function of suppressing spreading by wetting of a resin material before solidification. Specifically, a material having surface free energy lower than that of the metal material is selected. The partition portion is, for example, a wall formed on the second conductive layer and made of a resin material different from the resin material for forming the resin layer, a resist material, or a set of slits or holes formed by removing a portion of the second conductive layer.

As described above, in addition to irradiation of silver with light, contact between silver and moisture present around the LED element is also a factor of migration. However, compared with shielding light, suppressing contact with moisture can be achieved more easily. This is because, in general, an absorptance of light in a substance used for light shielding varies depending on the wavelength of light.

In the light source device having the above configuration, the metal bonding layer formed around the LED element, that is, a portion where silver and moisture may come into contact, is covered with the resin layer. Therefore, contact between the metal bonding layer and moisture present around the LED element is suppressed, and occurrence of migration is suppressed.

Here, a description will be given of mounting the LED element on the flat second conductive layer provided on the main surface of the LED substrate, filling the gap between the LED element and the second conductive layer, and covering the surface of the metal bonding layer spread around the LED element with the resin layer.

The resin layer is formed by supplying the resin material before solidification to the surface of the metal bonding layer and solidifying the resin material by heat treatment or irradiation with ultraviolet light. At this time, the liquid resin material may be directly applied to the surface of the metal bonding layer. However, when the LED element is thin and small, direct application to the surface of the metal bonding layer becomes difficult. Furthermore, when the arrangement density of the LED elements is high, direct application to the surface of the metal bonding layer becomes even more difficult.

Therefore, the present inventor has realized that, on the conductive layer or the metal bonding layer, each made of a metal material, surface free energy is relatively high and the resin material before solidification is likely to spread by wetting, and has considered utilizing this characteristic.

In the light source device having the above configuration, even without direct application to the metal bonding layer, when a sufficient amount of the resin material before solidification is supplied to any position on the second conductive layer, the resin naturally spreads by wetting. By limiting a region in which the resin spreads by wetting (a region in which the resin material contacts the second conductive layer), spreading by wetting of the resin to an undesired region can be limited. For example, around the LED element, the resin material can be supplied to the entire surface of the metal bonding layer.

That is, with the above configuration, even on a flat second conductive layer, the resin layer is formed over the entire surface of the metal bonding layer present around the LED element, without forming any complicated structure on the LED substrate. By forming the narrow path on the second conductive layer on which the resin material spreads by wetting, the resin material easily spreads by wetting along the narrow path, and the resin layer can be formed around the LED element. By forming the resin in the narrow path, even when the amount of the resin material before solidification supplied to the second conductive layer (supply amount) is small, the resin layer can be easily formed along the narrow path.

There is no need to increase the amount of the resin material supplied to the second conductive layer, and the resin material can be prevented from spreading by wetting into an undesired region. By spreading by wetting of the resin material along the narrow path, control becomes easier so that the resin material does not creep onto the light-emitting surface of the LED element. That is, by employing a structure in which the light-emitting surface of the LED element is not covered with the resin material, absorption of light emitted from the light-emitting surface (e.g., ultraviolet light) by the resin material can be prevented.

In addition to the above examination, the present inventor has also considered the presence of the wire when examining the path along which the resin material spreads by wetting, and examined the structure of the second conductive layer around the LED element.

As the wire, a wire made of a metal material is generally employed from the viewpoint of conductivity, flexibility, ease of processing, and the like. Therefore, when the wire comes into contact with the resin material before solidification, the resin material may be drawn up. When the wire draws up the resin material, the resin material may unintentionally spread by wetting onto the light-emitting surface of the LED element, thereby reducing the luminance of the LED element. Accordingly, contact between the wire and the resin material needs to be avoided in consideration of compatibility with various manufacturing steps, depending on the order of the manufacturing steps. However, when the resin material covering the surface of the metal bonding layer is to be applied to the periphery of the LED element in the direction in which the wire extends, avoidance of contact between the wire and the resin material becomes difficult.

On the other hand, in the structure of the light source device described above, the narrow path is formed along a region in which spreading by wetting of the resin material is desired, and the resin layer is formed in the narrow path. Therefore, the resin material spreads by wetting along the narrow path, and even with a small amount, the resin material can easily form the resin layer covering the surface of the metal bonding layer. Since the resin layer is formed along the narrow path, the resin layer is unlikely to swell, so that contact between the wire and the resin material can be easily avoided.

Note that the resin layer can also be easily formed by forming the narrow path along the side surface of the LED element, even when the narrow path is not formed in the direction in which the wire extends. For example, the narrow path may be formed along a portion of the side surface of the LED element, or may be formed along the entire periphery of the LED element.

The light source device having the above configuration has a structure in which the wire and the resin material spreading by wetting on the surfaces of the second conductive layer and the metal bonding layer are less likely to come into contact. Therefore, unintended spreading by wetting of the resin material for forming the resin layer along the wire on the light-emitting surface can be easily avoided.

Note that one end portion of the wire is bonded onto the light-emitting surface, and when the wire extends toward the first conductive layer side, the wire once passes a position higher than the LED element with respect to the main surface of the LED substrate, and then the other end portion is bonded at a predetermined position of the first conductive layer. Therefore, in the vicinity of the LED element, the wire is necessarily routed to avoid the resin material. However, due to the operation of the bonding process, the height from the main surface of the LED substrate is likely to change in the vicinity of the position corresponding exactly to an intermediate portion between bonding positions, and the wire and the second conductive layer are likely to approach each other. Further, undesired external stress may cause the wire to approach the second conductive layer. In this case, the wire may be short-circuited when the wire approaches too close to the second conductive layer, and the resin layer is desirably interposed between the second conductive layer and the wire.

Also from this viewpoint as well, it is preferable that, in the direction in which the wire extends, the resin layer is formed in the narrow path along the side surface of the LED element between the LED element and the end portion of the second conductive layer or the partition portion provided on the second conductive layer.

In the light source device, a surface of the resin layer may gradually decrease in height with increasing distance from the LED element, the height being defined with reference to the main surface of the LED substrate, and, in a cross section obtained by cutting along a plane that is parallel to a side surface of the LED element and passes through the LED element, a linear shape or a concave shape may be exhibited.

With the above configuration, contact between the resin material before curing for forming the resin layer and the wire can be avoided more suitably. Depending on the viscosity of the resin material or the like, when a resin material having relatively low viscosity is employed and the resin material is supplied along the narrow path as it is without using a mold or the like, the resin layer is likely to be naturally formed to exhibit the above shape.

The light source device may further include:
a mounting portion formed within a region in which the LED element is placed, the region being surrounded by the end portion of the second conductive layer or the partition portion provided on the second conductive layer, as viewed in a normal direction of the main surface of the LED substrate in a state where the LED element is placed; and
an extension portion extending outward from the mounting portion in a direction away from the LED element as viewed from the LED element.

Moreover, in the light source device,
the partition portion is preferably formed of a material having surface free energy smaller than surface free energy of the metal material forming the second conductive layer.

Further, in the light source device,
the partition portion may be provided to partition a part of a region on the first conductive layer, and the wire may be connected to the region partitioned by the partition portion.

With the above configuration, the resin material before solidification for forming the resin layer can be prevented from unnecessarily spreading by wetting on the second conductive layer.

Depending on a device for supplying a resin material before solidification for forming a resin layer, a discharge port for supplying the resin material may be large, and accurate supply of the resin material to a narrow region may be difficult. Therefore, when the extension portion continuous with the mounting region is formed as in the above configuration, supply of the resin material becomes relatively easy. Moreover, by forming the extension portion in a prescribed predetermined size and shape, the extension portion can also be used as alignment for detecting a position at which the resin material is supplied.

The extension portion is more preferably formed to be continuous with only a part of the mounting region. This is because, when the extension portion is formed on the entire circumference of the mounting region, the supplied resin material spreads by wetting even outside the mounting region, and control of spreading by wetting of the resin becomes difficult. Specifically, the distance over which the extension portion and the mounting region are continuous is more preferably suppressed to 50% or less of the periphery of the mounting region.

Further, in the light source device,
an area of the extension portion is preferably smaller than a placement area of the LED element.

Further, in the light source device,
a plurality of the extension portions may be provided corresponding to the mounting portion.

In the light source device,
at least a portion of the second conductive layer that is located between the LED element and the first conductive layer may be covered with the resin layer.

The wire may be largely bent between the LED element and the first conductive layer due to deformation caused by contact during assembly work, operation during bonding, deformation caused by long-term application of gravity or heat, or the like. Therefore, when the second conductive layer located between the LED element and the first conductive layer is exposed, the bent wire may come into contact with the exposed portion and may short-circuit the first conductive layer and the second conductive layer.

Therefore, with the above configuration, even when the wire is bent, a short circuit between the first conductive layer and the second conductive layer due to the wire is avoided.

### EFFECT OF THE INVENTION

According to the present invention, a light source device in which occurrence of migration is suppressed can be realized without requiring a complicated structure.

### BRIEF DESCRIPTION OF THE DRAWINGS

Fig. 1 is a schematic view of the overall configuration of one embodiment of a light source device as viewed from the +Z side.
Fig. 2 is a view schematically illustrating adjacent conductive layers.
Fig. 3A is an enlarged view of region R1 in Fig. 2.
Fig. 3B is a view of a state in which a resin layer formed on a first conductive layer in Fig. 3A is removed.
Fig. 4A is a cross-sectional view taken along line A-A in Fig. 3A.
Fig. 4B is a schematic cross-sectional view of one embodiment of the light source device.
Fig. 5A is a schematic view of another embodiment of the light source device as viewed from a Z direction.
Fig. 5B is a schematic view of another embodiment of the light source device as viewed from the Z direction.
Fig. 5C is a schematic view of another embodiment of the light source device as viewed from the Z direction.
Fig. 5D is a schematic view of another embodiment of the light source device as viewed from the Z direction.
Fig. 5E is a cross-sectional view taken along line B-B in Fig. 5D.

### MODE FOR CARRYING OUT THE INVENTION

Hereinafter, a light source device of the present invention will be described with reference to the drawings. Note that each of the following drawings is schematically illustrated, and the dimensional ratios and quantities illustrated in the drawings do not necessarily match the actual dimensional ratios and quantities.

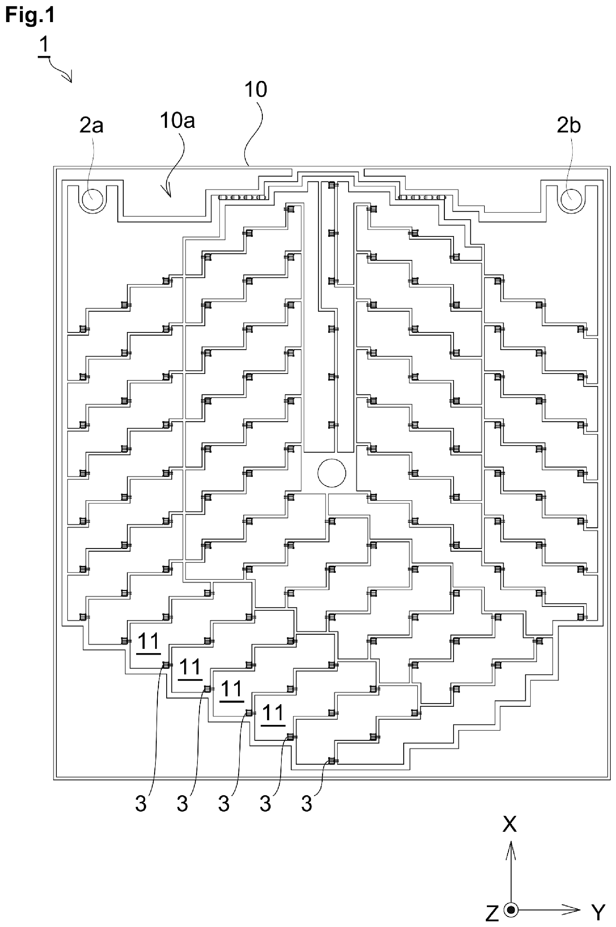

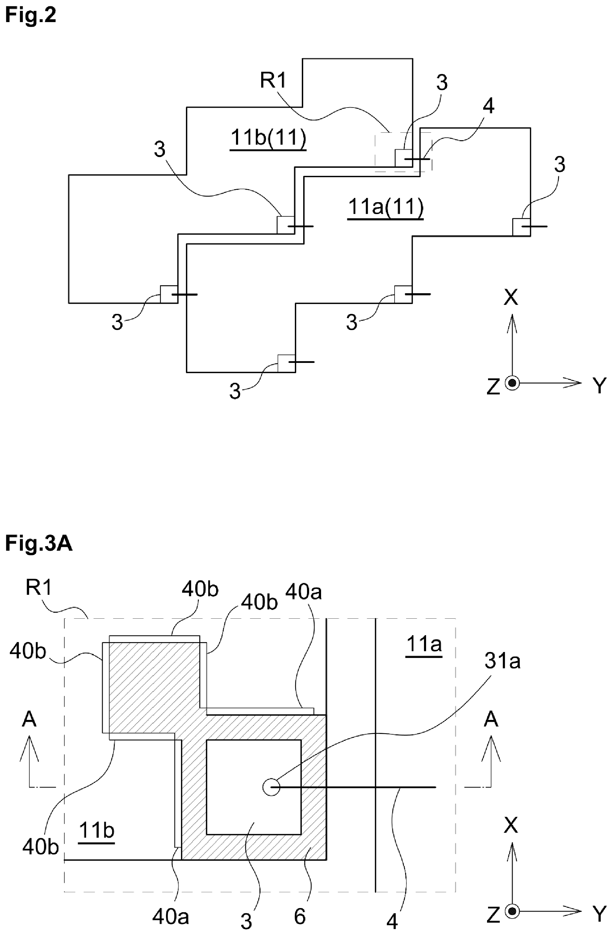

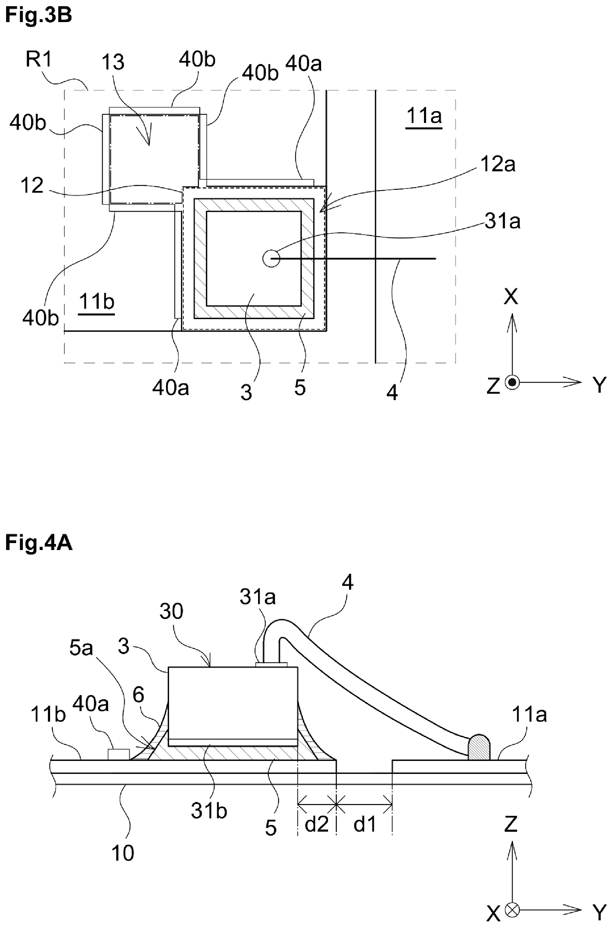

Fig. 1 is a schematic view of the overall configuration of one embodiment of a light source device 1 as viewed from the +Z side. Fig. 2 is a view schematically illustrating adjacent conductive layers (11a, 11b). Fig. 3A is an enlarged view of region R1 in Fig. 2, and Fig. 3B is a view in a state where the resin layer 6 formed on the first conductive layer in Fig. 3A is removed. Fig. 4A is a cross-sectional view taken along line A-A in Fig. 3A.

As illustrated in Figs. 1 to 4A, a light source device 1 according to the present embodiment includes an LED substrate 10, a pair of substrate electrodes (2a, 2b), an LED element 3, a wire 4, a conductive layer 11, a partition portion 40a, a metal bonding layer 5, and a resin layer 6. In the present embodiment, as an example of the light source device 1, a plurality of LED elements 3, a plurality of wires 4, and a plurality of conductive layers 11 are provided. However, the light source device 1 may be configured to include one LED element 3, one wire 4, and one conductive layer 11.

In the following description, as illustrated in Fig. 1, a plane parallel to a main surface 10a of the LED substrate 10 is an XY plane, and a direction orthogonal to the XY plane, that is, a normal direction of the main surface 10a of the LED substrate 10, is a Z direction. As illustrated in Fig. 2, a direction in which the wire 4 extends will be described as a Y direction.

When positive and negative orientations are distinguished in expressing a direction, the direction is described with a positive or negative sign, such as "+Z direction" or "-Z direction", and when positive and negative orientations are not distinguished, the direction is simply described as "Z direction".

As illustrated in Fig. 4A, the LED element 3 is an element having a structure in which a pair of electrodes (31a, 31b) is formed on surfaces facing each other in the Z direction, an electrode to which the wire 4 on the +Z side is connected corresponds to the first electrode 31a, and an electrode formed on a surface on the -Z side corresponds to the second electrode 31b.

The surface on the +Z-side of the LED element 3 on which the first electrode 31a is formed is a light-emitting surface 30 for extracting light generated inside from a region different from the region of the first electrode 31a. Regarding the LED element 3 employed in the present invention, the wavelength band of light to be emitted is arbitrary.

The wire 4 is a metallic wire material that connects the first electrode 31a of the LED element 3 and the first conductive layer 11a. The material of the wire 4 is, for example, gold (Au).

In the LED substrate 10, as illustrated in Fig. 1, a plurality of conductive layers 11 are formed, and a plurality of LED elements 3 are placed on each conductive layer 11. In the light source device 1 according to the present embodiment, the conductive layers 11 are connected in series by the plurality of LED elements 3 and the wire 4, and all the LED elements 3 are turned on by supplying predetermined power between the substrate electrodes (2a, 2b).

As illustrated in Fig. 2, in a pair of conductive layers 11 adjacent to each other and connected by the LED element 3 and the wire 4, the conductive layer 11 to which the wire 4 is connected corresponds to the first conductive layer 11a, and the conductive layer 11 on which the LED element 3 is placed corresponds to the second conductive layer 11b.

Note that whether each conductive layer 11 corresponds to the first conductive layer 11a or the second conductive layer 11b is not uniquely determined, and is determined depending on which LED element 3 is focused on.

The conductive layer 11 is a layer made of a metal material having conductivity, and as a specific example, is formed of a material containing copper (Cu), gold (Au), nickel (Ni), palladium (Pd), an alloy thereof, or the like.

Adjacent conductive layers 11 forming a pair of the first conductive layer 11a and the second conductive layer 11b are formed to be separated by a distance d1, as illustrated in Fig. 4A. The distance d1 needs to ensure sufficient insulation between the first conductive layer 11a and the second conductive layer 11b, and also needs to ensure a sufficient distance so that the first conductive layer 11a and the second conductive layer 11b are not short-circuited due to adhesion of foreign matter or the like.

If the distance d1 is excessively large, a problem such as electrical resistance of the wire 4 or deflection of the wire 4 may arise. In view of the above, the distance d1 is preferably 0.10 mm or more and 5.00 mm or less, and more preferably 0.10 mm or more and 3.00 mm or less.

On the conductive layer 11, a partition portion (40a, 40b) for suppressing spreading by wetting of a resin material, the resin material forming a resin layer 6 to be described later, is formed. The partition portion 40a is, for example, a structure that surrounds a mounting portion 12 (a region surrounded by a broken line in Fig. 3B) in which the LED element 3 is mounted, together with the end portion of the second conductive layer 11b. The mounting portion 12 here refers to a region of the second conductive layer 11b within a mounting region defined as a range 20% larger than one side of the LED element 3 as viewed in the Z direction. In addition, here, the partition portion 40b is illustrated as a structure forming an extension portion 13 (a region surrounded by an alternate long and short dash line in Fig. 3B) having an area smaller than a placement area of the LED element 3, for supplying a resin material forming the resin layer 6.

The partition portion (40a, 40b) is a structure made of a material having surface free energy smaller than that of a metal material. The material having surface free energy smaller than that of the metal material is, for example, a resist, a resin, or the like. Note that each region illustrated in Fig. 3B is a region partitioned by the partition portion (40a, 40b) and the end portion of the second conductive layer 11b, and is formed to partition the region of the mounting portion 12. However, for convenience of illustration, the broken line and an alternate long and short dash line are illustrated at positions slightly shifted inward with respect to the actual region.

The partition portion (40a, 40b) is provided to receive a resin material for forming the resin layer 6 and guide the resin material to cover the surface of the metal bonding layer 5. Thus, in consideration of the fact that the resin material generally has a certain degree of viscosity as compared with water, the partition portion (40a, 40b) may be continuously extended to partition the mounting portion 12, or may be discretely disposed to partition the mounting portion 12.

In the present embodiment, one mounting portion 12 is connected to one extension portion 13, but a plurality of mounting portions 12 may be connected to one extension portion 13.

As illustrated in Fig. 4A, the metal bonding layer 5 is a layer that connects the second conductive layer 11b and the second electrode 31b of the LED element 3, and is a layer exhibiting conductivity. As illustrated in Figs. 3B and 4A, the metal bonding layer 5 is formed in a gap between the LED element 3 and the second conductive layer 11b and around the LED element 3.

When the LED element 3 is placed on the second conductive layer 11b coated with silver paste, the silver paste is pushed by the LED element 3 and spreads so as to fill the gap between the second electrode 31b and the second conductive layer 11b. Simultaneously, as illustrated in Fig. 3B, excess silver paste spreads so as to be pushed out around the LED element 3. The silver paste thus spread is solidified by heat treatment, drying treatment, or the like, whereby the metal bonding layer 5 is formed between the LED element 3 and the second conductive layer 11b on the second conductive layer 11b and around the LED element 3.

As illustrated in Figs. 3A to 4A, the LED element 3 is placed at a position separated from the end portion of the second conductive layer 11b by a certain distance d2. Such a method for placement can effectively prevent excessive silver paste from flowing out from between the LED element 3 and the conductive layer 11 and flowing into between the first conductive layer 11a and the second conductive layer 11b, which would cause a short circuit. In the present embodiment, the LED element 3 is disposed such that the side surface on the +Y side of the LED element 3 and the end portion of the second conductive layer 11b are separated by the distance d2, and the buffer region 12a extending along each side surface of the LED element 3 is formed around the LED element 3.

As illustrated in Fig. 4A, it is also assumed that, as the wire 4 approaches the first conductive layer 11a, the wire 4 droops toward the LED substrate 10, particularly from the vicinity of a position where the wire 4 passes by the side surface of the LED element 3. Therefore, the distance d2 is configured to be smaller than the distance d1 from the viewpoint of preventing the wire 4 from coming into contact with the resin material before solidification as much as possible.

The LED element 3 of the present embodiment is similarly disposed on the -X side of the LED element 3 so as to be separated from the end portion of the second conductive layer 11b by the distance d2. However, the separation distance between the LED element 3 and the end portion of the second conductive layer 11b on the -X side may differ from the distance d2.

As illustrated in Figs. 3A and 4A, the resin layer 6 is an insulating layer that covers the surface of the metal bonding layer 5 cured around the LED element 3 and the second conductive layer 11b located on the +Y side of the LED element 3 in a direction in which the wire 4 passes, and is a layer that hardly allows moisture to pass therethrough. As a material constituting the resin layer 6, for example, a hydrophobic resin such as a silicone resin can be employed. When the wire 4 passes through a position sufficiently away from the second conductive layer 11b, the second conductive layer 11b in a portion where the wire 4 passes on the +Z side does not necessarily have to be entirely covered with the resin layer 6. With respect to a position of the second conductive layer 11b where the wire 4 does not pass on the +Z side, whether or not the resin layer 6 is formed is arbitrary except for a portion where the metal bonding layer 5 is formed. For example, the resin layer 6 may be formed on at least a portion of the partition portion (40a, 40b) while covering the periphery of the LED element 3.

As illustrated in Fig. 4A, the resin layer 6 of the present embodiment is formed to have a concave shape in a cross section obtained by cutting along a plane parallel to the side surface of the LED element 3 and passing through the LED element 3.

In the resin layer 6, a resin material dropped onto the extension portion 13 of the second conductive layer 11b in the state illustrated in Fig. 3B spreads by wetting on the second conductive layer 11b formed of a metal material having relatively large surface free energy. When the resin material spreads by wetting to the periphery of the LED element 3, the resin material spreads by wetting on the surface of the metal bonding layer 5 that has relatively large surface free energy, similarly to the second conductive layer 11b, and reaches the side surface of the LED element 3. At this time, the resin material actively spreads by wetting on the second conductive layer 11b and the metal bonding layer 5 rather than on the side surface of the LED element 3, and thus spreads so as to cover the periphery of the LED element 3 without covering the light-emitting surface 30 of the LED element 3. In addition, by forming a narrow path between the LED element 3 and an end portion of the second conductive layer 11b or between the LED element 3 and a partition portion (40a, 40b) provided on the second conductive layer 11b, the resin material spreads by wetting along the narrow path and is less likely to spread to an undesired region.

In this manner, the resin material spreads by wetting on the second conductive layer 11b and the surface of the metal bonding layer 5, and is dried and solidified, whereby the resin layer 6 having a shape as illustrated in Figs. 3A and 4A is formed.

The shape of the resin layer 6 in the A-A cross section is preferably linear or concave from the viewpoint of avoiding contact with the wire 4, but may be convex when a sufficient distance can be ensured between the resin layer 6 and the wire 4. Note that the shape of the resin layer 6 can be adjusted, for example, by controlling the viscosity or the like of the resin.

In the light source device 1 having the above configuration, the metal bonding layer 5 formed around the LED element 3, that is, a portion where silver and moisture may come into contact, is covered with the resin layer 6. Therefore, contact between the metal bonding layer 5 and moisture present around the LED element 3 is suppressed, and occurrence of migration is suppressed.

In the light source device 1 having the above configuration, without forming any complicated structure on the LED substrate 10, the resin layer 6 is formed on the flat second conductive layer 11b over the entire surface of the metal bonding layer 5 present around the LED element 3. By appropriately adjusting the amount of the resin material to be supplied to the second conductive layer 11b, the resin material can be controlled so as not to creep onto the light-emitting surface 30 of the LED element 3.

Moreover, the light source device 1 having the above configuration has a structure in which the wire 4 and the resin material spreading by wetting on the surfaces of the second conductive layer 11b and the metal bonding layer 5 are less likely to come into contact. Therefore, unintended spreading by wetting of the resin material for forming the resin layer 6 along the wire 4 on the light-emitting surface 30 can be easily avoided.

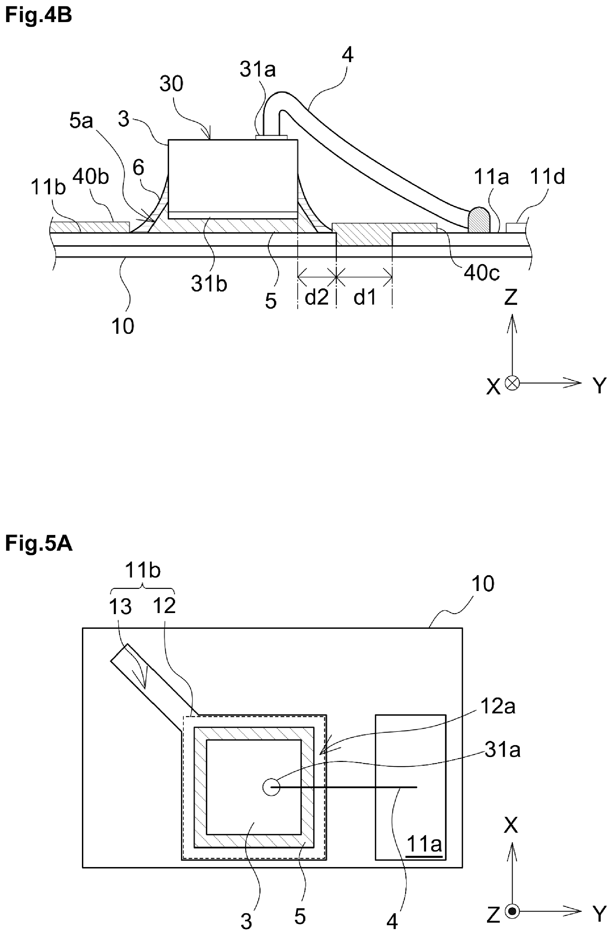

Fig. 4B is a schematic cross-sectional view illustrating the same portion as Fig. 4A of one embodiment of the light source device 1 different from the configuration described above. As illustrated in Fig. 4B, a partition portion 40c may be formed between the first conductive layer 11a and the second conductive layer 11b. In the present embodiment, as illustrated in Fig. 4B, partition portions (40a, 40c) are formed to cover a wider range of the first conductive layer 11a and the second conductive layer 11b. As a result, the wire 4 is less likely to come into contact with the first conductive layer 11a or the second conductive layer 11b, and a short circuit is less likely to occur. The narrow path here is formed in a gap between the LED element 3 and the partition portion 40c provided on the second conductive layer 11b, and a narrow path narrower than the distance d2 is formed. Note that the partition portion 40c in this configuration has the same function as the partition portions (40a, 40b), but these partition portions need not all be formed of the same material.

### [Other embodiments]

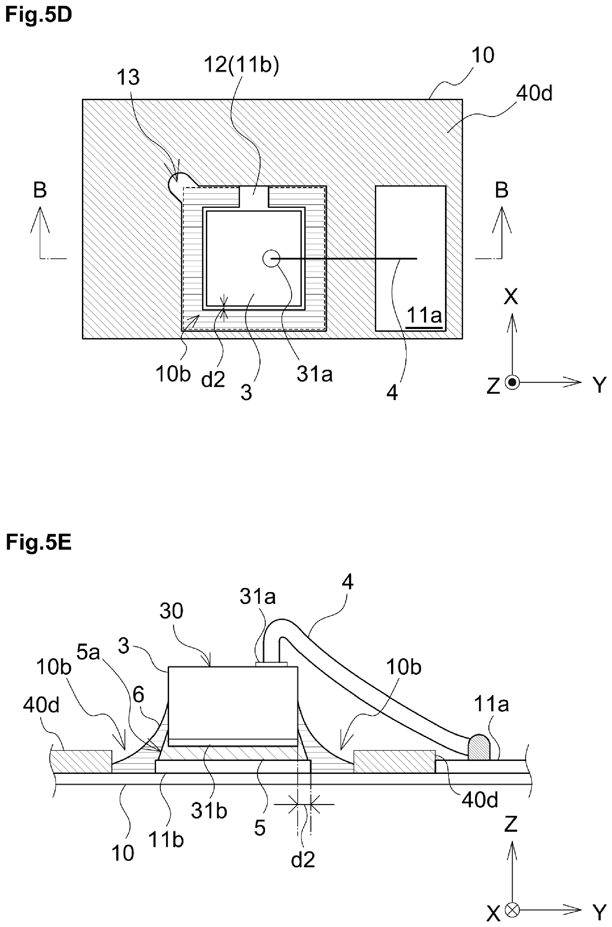

Other embodiments will now be described.
<1> Figs. 5A to 5D are schematic diagrams when other embodiments of the light source device 1 are viewed from the Z direction, and Fig. 5E is a cross-sectional view taken along line B-B in Fig. 5D. The light source device 1 described here is described on the premise, for convenience of description, that one LED element 3 is placed on the LED substrate 10. However, it is naturally assumed that the light source device 1 is also applicable to a case in which a plurality of LED elements 3 are mounted, as in the embodiment described above.

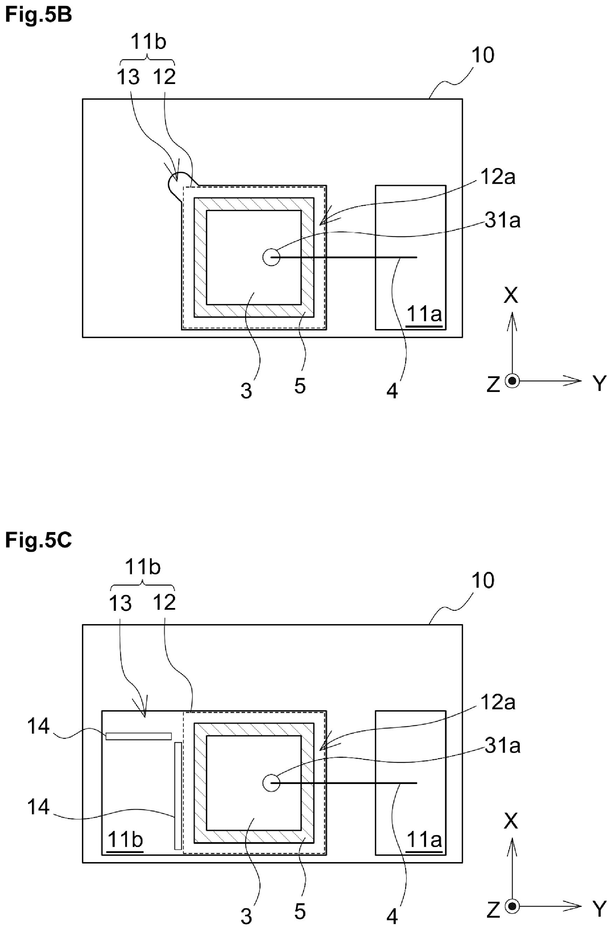

As illustrated in Figs. 5A and 5B, the second conductive layer 11b may include the mounting portion 12 and the extension portion 13 without providing a partition portion. The shape of the extension portion 13 is arbitrary as long as the region of the extension portion 13 is continuous with the region of the mounting portion 12 of the LED element 3 and extends outward beyond the region of the mounting portion 12.

Further, as illustrated in Fig. 5C, the mounting portion 12 and the extension portion 13 may be formed by a slit 14 provided in the second conductive layer 11b. Moreover, the slit 14 may be replaced by a set of through holes or the like.

Figs. 5D and 5E illustrate an embodiment in which the second conductive layer 11b is smaller than the mounting region 10b for the LED element 3. The mounting region 10b here is defined in a range 20% larger than one side of the LED element 3. The "narrow path" in the present embodiment is a region having a width corresponding to the distance d2 between the LED element 3 and the end portion of the second conductive layer 11b. According to the present embodiment, by making the second conductive layer 11b narrower than the mounting region 10b, a narrower narrow path can be formed along the side surface of the LED element 3.

For example, by forming a narrow path in which the distance between the LED element 3 and the end portion of the second conductive layer 11b is 0.02 mm, the resin can be spread by wetting along the narrow path.

When the narrow path is formed by the partition portion 40d, if the narrow path is excessively narrow, the resin material before solidification is more likely to fill the narrow path in the process of spreading by wetting of the resin material. Although this provides an advantage in that the discharge amount of the resin can be reduced, when the discharge amount of the resin material cannot be adjusted with high accuracy, the discharge amount of the resin material tends to become excessive with respect to the narrow path. If the discharge amount becomes excessive, the likelihood that the resin material creeps onto the light-emitting surface 30 of the LED element 3 increases.

Therefore, by narrowing the region of the second conductive layer 11b in which the resin material spreads by wetting and partitioning, with the partition portion 40d formed of a resist on the LED substrate 10, a region larger than the second conductive layer 11b (here, partitioning a region corresponding to the mounting region 10b of the LED element 3 with the partition portion 40d (hatched region)), even when the discharge amount of the resin material becomes relatively excessive with respect to the narrow path, creeping of the resin material onto the light-emitting surface 30 of the LED element 3 can be suppressed effectively.

In Figs. 5D and 5E, the extension portion 13 continuous with the mounting region 10b is formed on the LED substrate 10, and by discharging the resin material to the extension portion 13, creeping of the resin material onto the light-emitting surface 30 of the LED element 3 can be suppressed more effectively. When the LED substrate 10 is made of a ceramic material, spreading by wetting of resin is more suppressed than when the LED substrate 10 is made of a metal material, and it is thus desirable that the extension portion 13 and the second conductive layer 11b be configured to be close to each other. Specifically, it is desirable to dispose the extension portion 13 and the second conductive layer 11b such that the shortest distance is 2 mm or less.
<2> In each of the embodiments described above, the extension portion 13 is formed on the second conductive layer 11b. However, when the resin material can be directly supplied onto the metal bonding layer 5, formation of the extension portion 13 is not required. For example, when the mounting portion 12 sufficiently larger than the placement area of the LED element 3 is formed, and a sufficient amount of resin is supplied to cover the entire second conductive layer 11b, the extension portion 13 is not necessarily formed.
<3> The configuration of the light source device 1 described above is merely an example, and the present invention is not limited to each illustrated configuration.

### DESCRIPTION OF REFERENCE SIGNS

- 1: Light source device
- 2a, 2b: Substrate electrode
- 3: LED element
- 4: Wire
- 5: Metal bonding layer
- 6: Resin layer
- 10: LED substrate
- 10a: Main surface
- 10b: Mounting region
- 11: Conductive layer
- 11a: First conductive layer
- 11b: Second conductive layer
- 12: Mounting portion
- 12a: Buffer region
- 13: Extension portion
- 14: Slit
- 30: Light-emitting surface
- 31a: First electrode
- 31b: Second electrode
- 40a, 40b, 40c, 40d: Partition portion
- d1, d2: Distance

## Claims

1. A light source device comprising:
a light-emitting diode (LED) substrate including, on a main surface, a first conductive layer and a second conductive layer that are each formed of a metal material and provided adjacent to each other;
an LED element placed on the second conductive layer and including a first electrode provided on a light-emitting surface and a second electrode provided on a surface opposite to the light-emitting surface;
a wire connecting the first electrode of the LED element and the first conductive layer;
a metal bonding layer formed on the second conductive layer between the LED element and the second conductive layer and containing at least silver; and
a resin layer formed along a periphery of the LED element and covering a surface of the metal bonding layer,
wherein, in a direction in which the wire extends, the resin layer is formed in a narrow path along a side surface of the LED element between the LED element and an end portion of the second conductive layer, or between the LED element and a partition portion provided on the second conductive layer.

2. The light source device according to claim 1, wherein a surface of the resin layer gradually decreases in height with increasing distance from the LED element, the height being defined with reference to the main surface of the LED substrate, and, in a cross section obtained by cutting along a plane that is parallel to a side surface of the LED element and passes through the LED element, a linear shape or a concave shape is exhibited.

3. The light source device according to claim 1 or 2, further comprising:
a mounting portion formed within a region in which the LED element is placed, the region being surrounded by the end portion of the second conductive layer or the partition portion provided on the second conductive layer, as viewed in a normal direction of the main surface of the LED substrate in a state where the LED element is placed; and
an extension portion extending outward from the mounting portion in a direction away from the LED element as viewed from the LED element.

4. The light source device according to claim 3, wherein the partition portion is formed of a material having surface free energy smaller than surface free energy of the metal material forming the second conductive layer.

5. The light source device according to claim 3, wherein the partition portion is provided to partition a part of a region on the first conductive layer, and the wire is connected to the region partitioned by the partition portion.

6. The light source device according to claim 3, wherein an area of the extension portion is smaller than a placement area of the LED element.

7. The light source device according to claim 3, wherein a plurality of the extension portions are provided corresponding to the mounting portion.

8. The light source device according to claim 1 or 2, wherein at least a portion of the second conductive layer that is located between the LED element and the first conductive layer is covered with the resin layer.
